# EUROPÄISCHE PATENTSCHRIFT

(11) **EP 2 863 421 B1**
(45) Veröffentlichungstag und Bekanntmachung des Hinweises auf die Patenterteilung: **14.04.2021**
(21) Anmeldenummer: 15150980.9
(22) Anmeldetag: 20.12.2010
(51) Int. Cl.: H01L 21/67, H01L 21/66, H01L 21/68, H01L 21/683

(54) **Aufnahmeeinrichtung zur Halterung von Wafern**
Holder device for holding wafers
Dispositif de réception destiné à supporter des wafers

(43) Veröffentlichungstag der Anmeldung: 22.04.2015
(62) Teilanmeldung aus: 10803232.7
(73) Patentinhaber: EV Group E. Thallner GmbH, 4782 St. Florian am Inn (AT)
(72) Erfinder: Wimplinger, Markus, 4910 Ried im Innkreis (AT); Wagenleitner, Thomas, 4971 Aurolzmünster (AT); Filbert, Alexander, 4782 St. Florian am Inn (AT)
(74) Vertreter: Schneider, Sascha

(56) Entgegenhaltungen:
- EP-A2- 0 320 297
- EP-A2- 0 411 916
- WO-A1-2009/133682
- DE-A1- 3 306 999
- US-A- 4 475 223
- US-A- 5 094 536
- US-A- 5 329 126
- US-A1- 2006 237 421

## Beschreibung

Die Erfindung betrifft eine Vorrichtung sowie ein Verfahren zum Ausrichten eines ersten Wafers mit einem zweiten Wafer gemäß den nebengeordneten Patentansprüchen.

Die Druckschrift EP 0 320 297 A2 offenbart ein System zur Temperaturkontrolle zum Vermeiden von lokalen Verformungen Ein ähnliches System ist in der Druckschrift DE 33 06 999 A1 beschrieben.

Solche Aufnahmeeinrichtungen oder Probenhalter beziehungsweise Chucks gibt es in vielfältigen Ausführungen und entscheidend für die Aufnahmeeinrichtungen ist eine ebene Aufnahmefläche beziehungsweise Halterungsfläche, damit die immer kleiner werdenden Strukturen auf immer größeren Waferflächen über die gesamte Waferfläche korrekt ausgerichtet und kontaktiert werden können. Dies ist besonders wichtig, wenn ein sogenannter Pre-Bonding-Schritt, welcher die Wafer mittels einer trennbaren Verbindung miteinander verbindet, vor dem eigentlichen Bondvorgang durchgeführt wird. Besonders wichtig ist eine hohe Ausrichtungsgenauigkeit der Wafer zueinander, sobald für alle auf einem oder beiden Wafern angeordneten Strukturen eine Ausrichtungsgenauigkeit oder insbesondere Verzerrungswerte von < 2µm erreicht werden soll. In der Nähe von Ausrichtungsmarken gelingt dies bei bekannten Aufnahmeeinrichtungen und Vorrichtungen zur Ausrichtung, sogenannte Aligner, insbesondere Bondaligner, sehr gut. Mit zunehmendem Abstand von den Ausrichtungsmarken ist eine kontrollierte und perfekte Ausrichtung mit Ausrichtungsgenauigkeiten oder insbesondere Verzerrungswerten besser als 2µm, vorzugsweise besser als 1µm und noch bevorzugter besser als 0,25µm nicht erreichbar

Eine derartige Vorrichtung zum Ausrichten zweier Wafer zueinander ist in Dokument WO 2009/133682 A1 offenbart.

Es ist die Aufgabe der vorliegenden Erfindung, gattungsgemäße Aufnahmeeinrichtungen derart zu verbessern, dass mit diesen eine genauere Ausrichtung erreicht werden kann.

Diese Aufgabe wird mit den Merkmalen der nebengeordneten Patentansprüche gelöst.

Vorteilhafte Weiterbildungen der Erfindung sind in den Unteransprüchen angegeben.

Die Erfindung basiert auf der Erkenntnis der Anmelderin gemäß den europäischen Patentanmeldungen EP 09012023 und EP 10 015 569, wobei mit erstgenannter eine Erfassung der gesamten Oberfläche, insbesondere der Positionen der Strukturen auf der Oberfläche eines jeden Wafers als Positionskarte des Wafers möglich ist. Die letztgenannte Erfindung betrifft eine Einrichtung zur Ermittlung von durch Dehnung und/oder Verzerrung eines ersten Wafers gegenüber einem zweiten Wafer beim Verbinden des ersten Wafers mit dem zweiten Wafer aufgetretenen lokalen Ausrichtungsfehlern mit:
- einer ersten Dehnungskarte von Dehnungswerten entlang einer ersten Kontaktfläche des ersten Wafers und/oder
- einer zweiten Dehnungskarte von Dehnungswerten entlang einer zweiten Kontaktfläche und
- Auswertungsmitteln zur Auswertung der ersten und/oder zweiten Dehnungskarten, durch welche die lokalen Ausrichtungsfehler ermittelbar sind.

Grundgedanke der vorliegenden Erfindung ist es dabei, eine Aufnahmeeinrichtung bestehend aus mehreren, voneinander unabhängigen aktiven Steuerelementen vorzusehen, mit welchen die Halterungsfläche der Aufnahmeeinrichtung, insbesondere in Form und/oder Temperatur, beeinflussbar ist. Dabei werden die aktiven Steuerelemente durch entsprechende Ansteuerung so verwendet, dass die mittels der Positionskarten und/oder Dehnungskarten bekannten lokalen Ausrichtungsfehler beziehungsweise lokalen Verzerrungen kompensiert beziehungsweise weitestgehend minimiert oder reduziert werden. Dabei werden nicht nur lokale Verzerrungen beseitigt, sondern eine sich aus den lokalen Verzerrungen insgesamt ergebende makroskopische Verzerrung oder Dehnung des Wafers in seinen Außenabmessungen wird gleichzeitig minimiert beziehungsweise korrigiert.

Somit ist es erfindungsgemäß insbesondere in Kombination mit den oben beschriebenen Erfindungen betreffend die Positionskarten, Dehnungskarten und/oder Spannungskarten sowie der dort offenbarten in-situ-Korrektur von Ausrichtungsfehlern beim Kontaktieren und Bonden der Wafer, möglich, durch aktive, insbesondere lokale Einwirkung auf Verzerrungen des Wafers ein noch besseres Ausrichtungsergebnis zu erreichen.

Gemäß einer vorteilhaften Ausführungsform der Erfindung ist vorgesehen, dass durch die Kompensationsmittel die Temperatur der Halterungsfläche lokal beeinflussbar ist. Eine lokale Temperaturerhöhung der Halterungsfläche führt zu einer lokalen Ausdehnung des auf der Halterungsfläche gehaltenen Wafers an dieser Position. Je höher der Temperaturgradient ist, desto mehr dehnt sich der Wafer an dieser Position aus. Basierend auf den Daten der Positionskarten und / oder Dehnungskarten, insbesondere der Vektorauswertung des Ausrichtungsfehlers, insbesondere für jede Position der Positionskarten und / oder Dehnungskarten, kann so gezielt auf lokale Verzerrungen des Wafers eingewirkt beziehungsweise diesen entgegengewirkt werden.

In diesem Zusammenhang ist als Vektorauswertung ein Vektorfeld mit Verzerrungsvektoren zu verstehen, das insbesondere mittels einer von zwei nachfolgend beschriebenen Erfindungsvarianten ermittelt wurde.

Die erste Variante bezieht sich auf Anwendungsfälle, in denen nur einer der beiden Wafer strukturiert ist. In diesem Fall ist es erfindungsgemäß vorgesehen, die Abweichung der Strukturen, insbesondere die Abweichung der geometrischen Form von der gewünschten Form zu erfassen. Von besonderem Interesse ist in diesem Fall die Abweichung der Form von Belichtungsfeldern, insbesondere Belichtungsfeldern eines Step & Repeat Belichtungsgerätes von der nominell erwarteten Form, die üblicherweise rechteckig ist. Diese Abweichungen, insbesondere das diese Abweichungen beschreibende Vektorfeld, kann basierend auf der Erfassung einer Positionskarte der einzelnen mit den Belichtungsfeldern korrespondierenden Ausrichtungsmarken gemäß EP 09012023 erfolgen. Alternativ kann dieses Vektorfeld auch basierend auf Spannungs- und/oder Dehnungskarten, die mittels EP 10 015 569.6 erfasst werden, ermittelt werden. Mit Vorteil kann dieses Vektorfeld aber erfindungsgemäß auch von jeder anderen, geeigneten Messeinrichtung ermittelt und eingelesen werden. Insbesondere eignen sich für diese Messung Step & Repeat Lithographiesysteme, die für die Erfassung dieser Daten mit einer speziellen Testmaske und/oder einer speziellen Testroutine betrieben werden.

Die zweite Variante bezieht sich auf Anwendungsfälle, in denen beide Wafer strukturiert sind. In diesem Fall ist es erfindungsgemäß vorgesehen, das Vektorfeld der Ausrichtungsabweichung insbesondere für alle Positionen der Positionskarten, insbesondere der ersten und zweiten Positionskarten gemäß EP 09012023 zu berechnen. Dieses Vektorfeld soll insbesondere für die, nach technologischen und/oder wirtschaftlichen Kriterien als ideal erachtete Ausrichtungsposition entsprechend der Ausführungen in EP 10 015 569.6 ermittelt werden.

In einer weiteren, vorteilhaften Ausführungsform der Erfindung ist vorgesehen, dass durch die Kompensationsmittel die Dehnung der Halterungsfläche, insbesondere durch Anordnung von, vorzugsweise einzeln ansteuerbaren, Piezoelementen an einer Rückseite der Halterungsfläche, lokal beeinflussbar ist. Durch Dehnung oder Schrumpfung, also negative Dehnung, der Halterungsfläche wird, insbesondere durch die von der Halterungsfläche auf den Wafer wirkende Haltekraft, auch der Wafer entsprechend verformt, insbesondere gedehnt oder geschrumpft, so dass auf diese Weise eine gezielte Beeinflussung des Wafers durch eine entsprechende Steuerungseinrichtung basierend auf den Werten der für diesen Wafer ermittelten Dehnungskarte möglich ist. Soweit durch die Kompensationsmittel die Form der Halterungsfläche, insbesondere durch, vorzugsweise mechanische, Einwirkung in einer Z-Richtung lokal beeinflussbar ist, besteht eine weitere Möglichkeit, Verzerrungen des Wafers an der Halterungsfläche entgegenzuwirken. Auch hier gilt, dass die Steuerung der Kompensationsmittel durch eine Steuereinrichtung erfolgt, die auf Grundlage der Werte der Positions- und/oder Dehnungskarten eine entsprechend gezielte, lokale Steuerung der Kompensationsmittel vornimmt.

Die Steuerungseinrichtung umfasst insbesondere eine Software zur Ausführung/Berechnung entsprechender Routinen.

Gemäß einer weiteren vorteilhaften Ausführungsform der Erfindung ist vorgesehen, dass die Halterungsfläche von einer Rückseite der Halterungsfläche durch die Kompensationsmittel lokal, insbesondere hydraulisch und/oder pneumatisch, mit Druck beaufschlagbar ist. Hierdurch kann ebenfalls auf die Form der Halterungsfläche Einfluss genommen werden, so dass sich die obengenannten Effekte ergeben. Die Steuerung erfolgt ebenfalls wieder durch die oben beschriebene Steuereinrichtung.

Mit Vorteil sind die Kompensationsmittel als eine Vielzahl aktiver Steuerelemente in der Aufnahmeeinrichtung, insbesondere in die Halterungsfläche integriert, vorzugsweise eingebettet, vorgesehen. Somit kann eine Aufnahme der Aufnahmeeinrichtung monolithisch ausgebildet sein, wie dies bei bekannten Aufnahmeeinrichtungen ebenfalls der Fall ist.

Dabei ist es von besonderem Vorteil, wenn jedes Steuerelement oder Gruppen von Steuerelementen gesondert ansteuerbar ist/sind. Entsprechend ist mit lokaler Ansteuerung gemeint, dass ein kleiner Ausschnitt insbesondere ein Ausschnitt kleiner als die Hälfte des Wafers, vorzugsweise kleiner als 1/4 des Wafers, vorzugsweise kleiner als 1/8 des Wafers, noch bevorzugter kleiner als 1/16 des Wafers, durch die Kompensationsmittel lokal ansteuerbar ist. Besonders vorteilhaft ist es, wenn die Kompensationsmittel auf jeden von einer eigenen Struktur belegten Bereich des Wafers mit mindestens einem Steuerelement einwirken können.

Die erfindungsgemäße Vorrichtung umfasst die vorbeschriebene Steuereinrichtung mit Vorteil in einer zentralen, für alle Steuerungsvorgänge zuständigen Steuereinheit. Erfindungsgemäß ist es jedoch denkbar, die Steuereinrichtung in der Aufnahmeeinrichtung, insbesondere als Modul einer Gesamtvorrichtung, vorzusehen.

Das erfindungsgemäße Verfahren umfasst eine nochmalige Erfassung von Positions- und/oder Dehnungskarten des ersten und/oder zweiten Wafers. Damit kann erfindungsgemäß nach der erfolgten Ausrichtung eine Überprüfung des Ausrichtungserfolgs vorgesehen werden. Entsprechend ist es denkbar, eine Ausgliederung eines Waferpaares mit zu großen Ausrichtungsfehlern vorzunehmen, um diese beispielsweise erneut erfindungsgemäß auszurichten oder zu entsorgen. Gleichzeitig können die erfassten Daten zur Selbstkalibrierung der Vorrichtung, insbesondere mittels der Steuereinrichtung, verwendet werden.

Weitere Vorteile, Merkmale und Einzelheiten der Erfindung ergeben sich aus der nachfolgenden Beschreibung bevorzugter Ausführungsbeispiele sowie anhand der Zeichnungen, diese zeigen in:

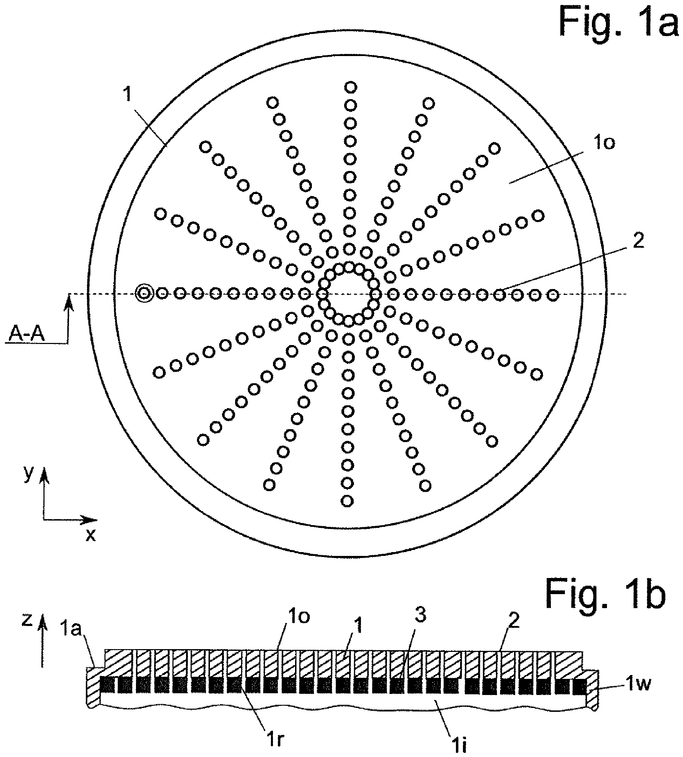

- Fig. 1a: eine Aufsicht auf eine erfindungsgemäße Aufnahmeeinrichtung in einer ersten Ausführungsform,
- Fig. 1b: eine Querschnittsansicht der Aufnahmeeinrichtung gemäß Schnittlinie A-A aus Figur 1a,
- Fig. 2a: eine Aufsicht auf eine erfindungsgemäße Aufnahmeeinrichtung in einer zweiten Ausführungsform,
- Fig. 2b: eine Querschnittsansicht der Aufnahmeeinrichtung gemäß Schnittlinie B-B aus Figur 2a,
- Fig. 3a: eine Aufsicht auf eine erfindungsgemäße Aufnahmeeinrichtung in einer dritten Ausführungsform,
- Fig. 3b: eine Querschnittsansicht der Aufnahmeeinrichtung gemäß Schnittlinie C-C aus Figur 3a,
- Fig. 4a: eine Aufsicht auf eine erfindungsgemäße Aufnahmeeinrichtung in einer vierten Ausführungsform und
- Fig. 4b: eine Querschnittsansicht der Aufnahmeeinrichtung gemäß Schnittlinie D-D aus Figur 4a.

In den Figuren sind gleiche und gleichwirkende Bauteile/Merkmale mit den gleichen Bezugszeichen gekennzeichnet.

Alle vier Ausführungsformen zeigen eine monolithische Aufnahme 1, die als flache, vorzugsweise kreisringförmige, Platte mit einer plan ebenen Halterungsfläche 1o zur Aufnahme und Halterung von Wafern versehen ist. Am Außenumfang weist die Aufnahme einen ringförmigen Absatz 1a auf.

Die Halterungsfläche 1o bildet eine Aufnahmeebene zur Aufnahme des Wafers, die sich in X- und Y-Richtung erstreckt. Hierzu senkrecht verläuft die Z-Richtung, in der die auf den Wafer wirkende Haltekraft gerichtet ist. Die Halterung des Wafers erfolgt durch Öffnungen 2, die in einer Vielzahl gleichförmig über die Halterungsfläche 10 verteilt angeordnet sind, um den Wafer an der Halterungsfläche 1o durch Beaufschlagung der Öffnungen 2 mit Unterdruck halten zu können. Je größer die Anzahl der Öffnungen 2 ist und je kleiner der Durchmesser der Öffnungen 2 ist, desto weniger führt der an den Öffnungen 2 anliegende Unterdruck zur Halterung des Wafers zu Verzerrungen des Wafers an den Öffnungen 2.

Der Unterdruck an den Öffnungen 2 wird über eine nicht dargestellte Vakuumeinrichtung angelegt, die einen rückseitig der Halterungsfläche 1o angeordneten Innenraum 1i mit Unterdruck beaufschlagt. Der Innenraum 1i ist weiterhin durch eine Umfangswand 1w der Aufnahme 1 begrenzt und gegenüber der Umgebung abgedichtet. Die Öffnungen 2 erstrecken sich von der Halterungsfläche 1o bis zum Innenraum 1i und sind somit gleichmäßig mit dem im Innenraum 1i vorherrschenden Unterdruck beaufschlagbar.

Der Innenraum 1i ist weiterhin durch eine gegenüberliegend zur Halterungsfläche 1o angeordnete Rückseite 1r und einen nicht dargestellten Boden des Innenraums 1i begrenzt, wobei die Rückseite 1r von den Öffnungen 2 durchsetzt ist.

Als aktive Steuerelemente sind an der Rückseite 1r eine Vielzahl von Heiz-/Kühlelementen, insbesondere ausschließlich Heizelemente 3, vorgesehen. Die Heizelemente 3 sind jeweils einzeln oder in Gruppen angesteuert, wobei die Steuerung durch eine nicht dargestellte Steuereinrichtung erfolgt. Beim Aufheizen eines der Heizelemente 3 heizt sich durch das sehr gut wärmeleitende Material, insbesondere Metall, der Aufnahme ein lokaler Abschnitt der Halterungsfläche 1o auf. Dies führt zu einer lokalen Ausdehnung eines auf der Halterungsfläche 1o liegenden Wafers in diesem Bereich. Somit kann bei entsprechend ausgerichtet auf der Aufnahmeeinrichtung aufgenommenem Wafer und bekannter Position von etwaigen Verzerrungen/Dehnungen gezielt durch Schalten einzelner oder mehrerer Heizelemente 3 eine Verformung des Wafers bewirkt werden, um lokale Verzerrrungen zu kompensieren. Hierdurch ergibt sich, insbesondere bei einer Vielzahl von lokalen Kompensationen, auch eine globale Kompensation von globalen Verzerrungen, insbesondere einer Änderung des Durchmessers des Wafers in X- und/oder Y-Richtung.

Ein besonderer Vorteil der Beeinflussung der Verzerrungen am Wafer mittels der Heiz- und / oder Kühlelemente liegt in der Möglichkeit, dies mit minimaler Verformung, insbesondere ohne Verformung der Halterungsfläche und/oder insbesondere ohne Verformung des Wafers in vertikaler Richtung beziehungsweise Z-Richtung, erreichen zu können. Als minimale Verformung in diesem Zusammenhang ist eine Verformung der Halterungsfläche und insbesondere des Wafers in vertikaler, das heißt senkrechter Richtung beziehungsweise in Z-Richtung im Verhältnis zur Auflagefläche von <5µm, mit Vorteil <2µm, bevorzugt <1µm und noch bevorzugter <0,5µm anzusehen. Dies ist insbesondere für das Herstellen von Pre-Bonding Verbindungen, beispielsweise für Pre-Bonds, die auf Van-der-Waals Verbindungen basieren, vorteilhaft. Aufgrund der Tatsache, dass hier die Halterungsfläche und insbesondere der Wafer eben gehalten werden kann, wird die bei derartigen Pre-Bonding Schritten übliche Bondwelle nicht in ihrer Ausbreitung durch Unebenheiten beeinflusst. Damit wird das Risiko, dass ungebondete Stellen (sogenannte Voids) verbleiben, stark reduziert. Für das Herstellen derartiger Pre-Bonding Verbindungen wird erfindungsgemäß eine Ebenheit der Halterungsfläche von <5µm, mit Vorteil <2µm, bevorzugt <1µm und noch bevorzugter <0,5µm über die gesamte Waferfläche angestrebt. Mit diesen Ebenheitswerten ist der Abstand zwischen dem höchsten und dem niedrigsten Punkt innerhalb jenes Teiles der Haltefläche, der mit dem Wafer in Kontakt ist, gemeint.

Die Heizelemente 3 sind mit Vorteil gleichmäßig unter der Halterungsfläche 1o verteilt. Mit Vorteil sind mehr als 10 Heizelemente 3, insbesondere mehr als 50 Heizelemente 3, vorzugsweise mehr als 100 Heizelemente 3, noch bevorzugter mehr als 500 Heizelemente 3, in der Aufnahmeeinrichtung vorgesehen. Diese Heizelemente bilden separat ansteuerbare Bereiche in der Halterungsfläche, die lokales Einwirken auf den Wafer ermöglichen. Mit Vorteil sind die einzelnen Bereiche der Halterungsfläche mit geeigneten Mitteln thermisch voneinander isoliert. Insbesondere sind die Bereiche in einer Form ausgebildet, die eine gleichmäßige und geschlossene Anordnung der einzelnen Segmente ermöglicht. Mit Vorteil eignet sich dafür die Ausbildung der Segmente als Dreiecke, Vierecke oder Sechsecke.

Als Heizelemente 3 sind insbesondere Peltierelemente geeignet.

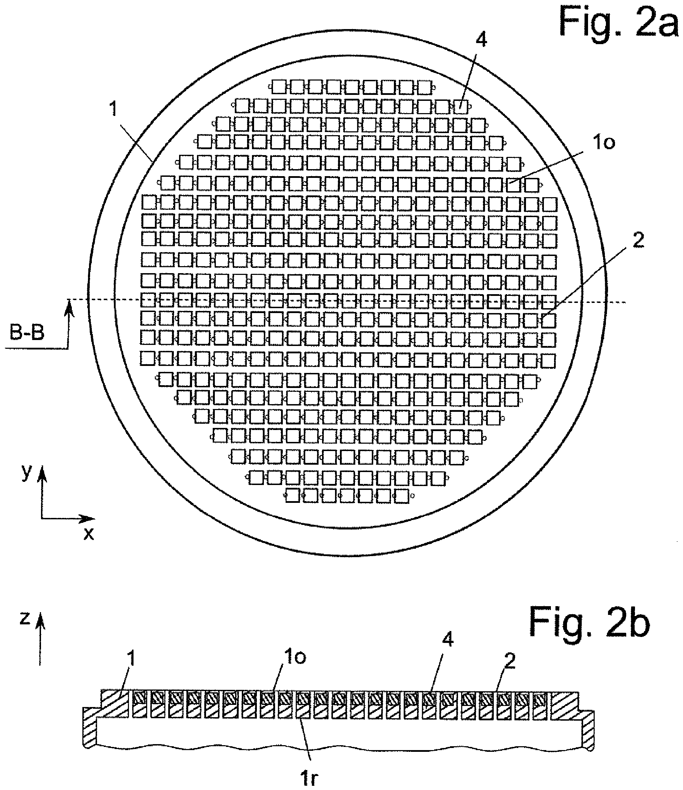

In der in den Figuren 2a und 2b gezeigten zweiten Ausführungsform sind keine Heizelemente 3 gezeigt und stattdessen oder in Kombination mit diesen sind Piezoelemente 4 an der Halterungsfläche 1o vorgesehen, vorzugsweise mit einem größeren Abstand zu der Rückseite 1r als zur Halterungsfläche 1o. Auf diese Weise ist ein gezieltes Einwirken auf die Halterungsfläche 1o möglich. Die Piezoelemente 4 können bei Aktivierung Dehnungen im Nanobis Mikrometerbereich bewirken.

Die Zahl der Piezoelemente 4 kann der obengenannten Zahl der Heizelemente 3 entsprechen, wobei eine Kombination der beiden Ausführungsformen erfindungsgemäß denkbar ist.

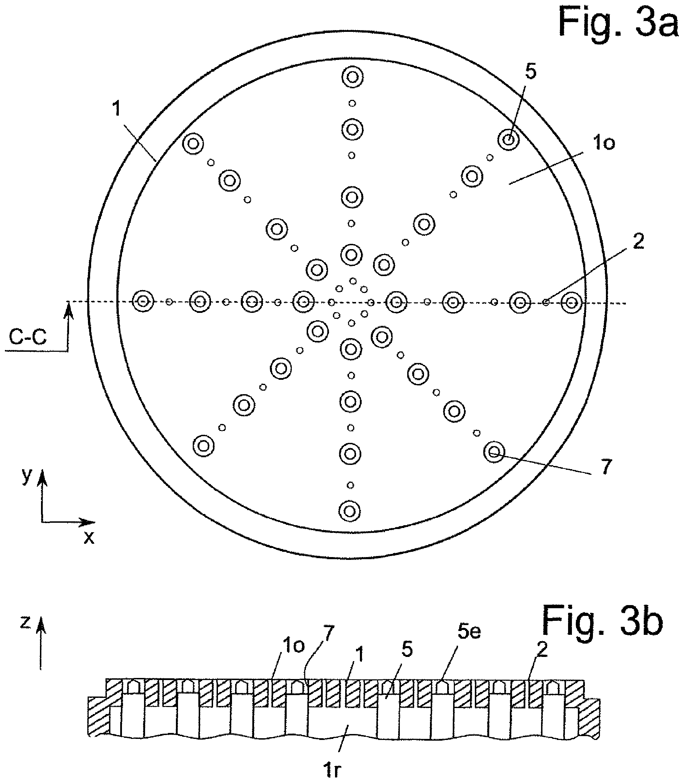

In der in den Figuren 3a und 3b gezeigten dritten Ausführungsform der Erfindung sind statt oder in Kombination mit den Heizelementen 3 und/oder den Piezoelementen 4 Stifte 5 vorgesehen, die an der Halterungsfläche 1o mit einem, insbesondere spitzen, Stiftende 5e enden. In der Ausgangslage der Stifte 5 ist das Stiftende 5e bündig mit der Halterungsfläche 1o. Soweit eine lokale Verzerrung eines Wafers im Bereich eines bestimmten Stiftes 5 als Information der Verzerrungskarte oder Dehnungskarte vorliegt, kann die Steuereinrichtung durch Ansteuerung einzelner oder mehrerer Stifte 5 lokal auf den Wafer einwirken, indem der Stift 5 beziehungsweise das Stiftende 5e in Z-Richtung in Richtung des Wafers bewegt wird. Das Stiftende 5e beaufschlägt damit den Wafer lokal mit einer Druckkraft, die für eine lokale Ausbeulung beziehungsweise Auslenkung des Wafers an dieser Stelle Sorge trägt. Der Stift 5 kann entweder als Ganzes in einer Führungsöffnung 7, die sich von der Halterungsfläche 1o bis zur Rückseite 1r erstreckt, gleitend geführt sein. Alternativ dazu ist nur das Stiftende 5e in dem Stift 5 bewegbar und der Stift 5 beziehungsweise der untere Abschnitt des Stifts gegenüber der Führungsöffnung 7 fixiert. Auf diese Weise kann eine besondere Abdichtung des Stifts 5 beziehungsweise der Stifte 5 gegenüber dem Innenraum 1r gewährleistet werden.

Die Anzahl der Stifte 5 entspricht der Anzahl der Piezoelemente 4 oder Heizelemente 3, wobei auch hier eine Kombination mit einer oder mehrerer der vorgenannten Ausführungsformen möglich ist.

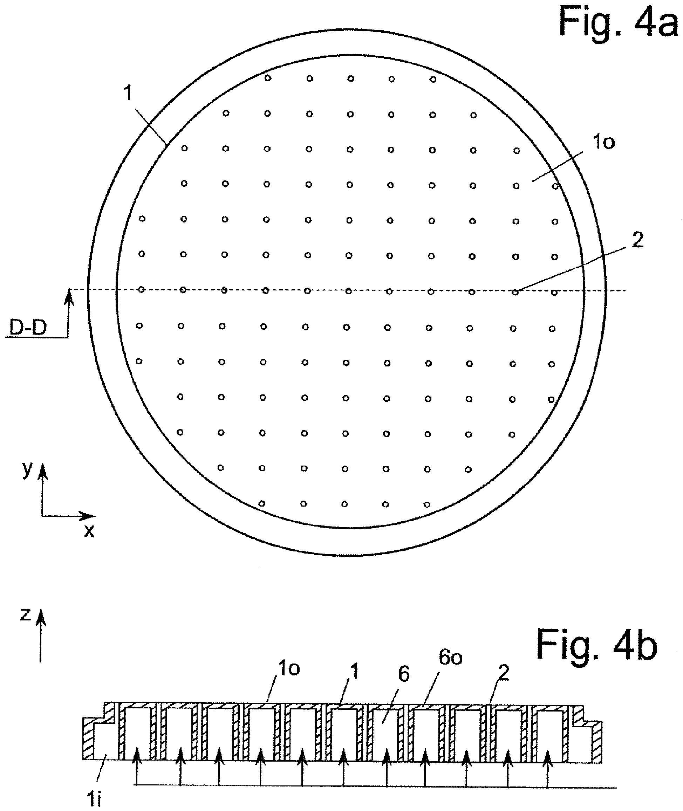

In der in Figur 4 gezeigten Ausführungsform weist die Aufnahme 1 eine Vielzahl von Druckkammern 6 auf, die mit ihrer in der Abbildung 4b gezeigten oberen Wand 6o die Halterungsfläche 1o bilden. Die Druckkammern 6 erstrecken sich durch den Innenraum 1i und sind gegenüber diesem abgedichtet. Jede der Druckkammern 6 oder Gruppen der Druckkammern 6 sind gesondert druckbeaufschlagbar, wobei die Steuerung durch die beschriebene Steuereinrichtung erfolgen kann. Bei Druckbeaufschlagung ist die Druckkammer 6 zumindest an ihrer oberen Wand 6o so ausgebildet, dass diese bei Druckbeaufschlagung nachgibt, also entweder dünner und/oder weicher als die anderen Begrenzungswände der Druckkammer 6 ausgebildet ist. Die Öffnungen 2 sind mit dem Innenraum 1i verbunden.

Erfindungsgemäß erfolgt eine lediglich minimale lokale Auslenkung der Halterungsfläche 1o durch die vorgenannten Kompensationsmittel 3, 4, 5, 6 um maximal 3µm, insbesondere maximal 1µm, vorzugsweise maximal 100 nm.

Um den lokalen Verzerrungen mit einer oder mehrerer der vorgenannten Ausführungsformen entgegenwirken zu können, ist es wie oben beschrieben notwendig, dass die Steuereinrichtung weiß, wo und in welchem Umfang beziehungsweise in welcher Richtung Verzerrungen im Wafer vorliegen. Erst dann ist ein gezieltes Einwirken beziehungsweise Entgegenwirken und Kompensieren der Verzerrungen möglich. Die Dehnungskarte eines jeden Wafers ergibt Aufschluss in Form von über den Wafer verteilten Dehnungsvektoren, die mit einer entsprechenden Messeinrichtung gemäß der EP 10 015 569.6 ermittelt worden sind. Entsprechende Steuerungsdaten können in der Steuerungseinheit, insbesondere empirisch ermittelt, hinterlegt sein, um für jeden Wafer eine individuelle Steuerung entsprechend der Dehnungskarte des Wafers an den durch die Positionskarte des Wafers vorgegebenen Positionen vornehmen zu können. Die Kompensation kann auf diese Weise automatisch während der Ausrichtung der Wafer durchgeführt werden.

Die aktiven Steuerelemente 3, 4, 5, 6 sind in den Figuren nicht maßstabsgetreu abgebildet und können auch verschiedene Größen oder Formen aufweisen.

### Bezugszeichenliste

- 1: Aufnahme
- 1a: ringförmiger Absatz
- 1i: Innenraum
- 1o: Halterungsfläche
- lw: Umfangswand
- 2: Öffnungen
- 3: Heiz-/Kühlelemente
- 4: Piezoelemente
- 5: Stifte
- 5e: Stiftende
- 6: Druckkammern
- 6o: obere Wand
- 7: Führungsöffnung

## Patentansprüche

1. Vorrichtung zum Ausrichten eines ersten Wafers mit einem zweiten Wafer mit folgenden Merkmalen:
- eine Einrichtung zur Erfassung von Positions- und/oder Dehnungskarten des ersten und/oder zweiten Wafers sowie zur Ermittlung von durch Dehnung und/oder Verzerrung des ersten Wafers gegenüber dem zweiten Wafer beim Verbinden des ersten Wafers mit dem zweiten Wafer aufgetretenen lokalen Ausrichtungsfehlern,
- mindestens eine Aufnahmeeinrichtung zur Aufnahme und Halterung von Wafern mit:
a) einer Halterungsfläche (1o),
b) Haltemitteln zur Halterung des Wafers an der Halterungsfläche (1o) und
c) Kompensationsmitteln (3, 4, 5, 6) zur aktiven, durch Temperatur und/oder Form steuerbaren, zumindest teilweisen Kompensation von lokalen und/oder globalen Verzerrungen des Wafers zur in-situ-Korrektur von Ausrichtungsfehlern beim Kontaktieren und Bonden der Wafer,
- Ausrichtungsmittel zur Ausrichtung der Wafer unter Kompensation durch die Kompensationsmittel,
- Überprüfungsmittel zur Überprüfung des Ausrichtungserfolgs und Mittel zur Selbstkalibrierung mittels der erfassten Daten.

2. Vorrichtung nach Anspruch 1, bei der durch die Kompensationsmittel (3, 4, 5, 6) die Temperatur der Halterungsfläche (1o) lokal beeinflussbar ist.

3. Vorrichtung nach einem der vorhergehenden Ansprüche, bei der als aktive Steuerelemente an einer Rückseite (1r) der Aufnahmeeinrichtung eine Vielzahl von Heiz-/Kühlelementen, insbesondere ausschließlich Heizelemente 3, vorzugsweise Peltierelemente, vorgesehen sind.

4. Vorrichtung nach einem der vorhergehenden Ansprüche, **dadurch gekennzeichnet, dass** durch die Kompensationsmittel (3, 4, 5, 6) die Form der Halterungsfläche (1o), insbesondere durch, vorzugsweise mechanische, Einwirkung in einer Z-Richtung, lokal beeinflussbar ist.

5. Vorrichtung nach einem der vorhergehenden Ansprüche, bei der die Halterungsfläche (1o) von einer Rückseite (1r) der Halterungsfläche (1o) durch die Kompensationsmittel (3, 4, 5, 6) lokal, insbesondere hydraulisch und/oder pneumatisch, mit Druck beaufschlagbar ist.

6. Vorrichtung nach einem der vorhergehenden Ansprüche, bei der die Kompensationsmittel (3, 4, 5, 6) als eine Vielzahl aktiver Steuerelemente (3, 4, 5, 6) in der Aufnahmeeinrichtung, insbesondere in die Halterungsfläche (1o) integriert, vorzugsweise eingebettet, vorgesehen sind.

7. Vorrichtung nach Anspruch 6, bei der jedes Steuerelement (3, 4, 5, 6) oder Gruppen von Steuerelementen (3, 4, 5, 6) gesondert ansteuerbar ist/sind.

8. Verfahren zum Ausrichten eines ersten Wafers mit einem zweiten Wafer mit folgenden Schritten, insbesondere folgendem Ablauf:
- Erfassung von Positions- und/oder Dehnungskarten des ersten und/oder zweiten Wafers,
- Aufnahme mindestens eines der Wafer auf einer Aufnahmeeinrichtung zur Aufnahme und Halterung von Wafern mit:
a) einer Halterungsfläche (1o),
b) Haltemitteln zur Halterung des Wafers an der Halterungsfläche (1o) und
c) Kompensationsmitteln (3, 4, 5, 6) zur aktiven, durch Temperatur und/oder Form steuerbaren, zumindest teilweisen Kompensation von lokalen und/oder globalen Verzerrungen des Wafers zur in-situ-Korrektur von Ausrichtungsfehlern beim Kontaktieren und Bonden der Wafer,
- Ausrichtung der Wafer unter Kompensation durch die Kompensationsmittel,
- Erfassung von Positions- und/oder Dehnungskarten des ersten und/oder zweiten Wafers zur Erfassung von durch Dehnung und/oder Verzerrung des ersten Wafers gegenüber dem zweiten Wafer beim Verbinden des ersten Wafers mit dem zweiten Wafer aufgetretenen lokalen Ausrichtungsfehlern,
- Überprüfung des Ausrichtungserfolgs und Selbstkalibrierung mittels der erfassten Daten.

## Claims

1. A device for the alignment of a first wafer with a second wafer with the following features:
- a device of the acquisition of position and/or strain maps of the first and/or second wafer as well as for ascertaining local alignment errors which have occurred due to the strain and/or distortion of the first wafer with respect to the second wafer during the joining of the first wafer with the second wafer,
- at least one supporting device for supporting and holding wafers with:
a) a holding surface (1o),
b) holding means for holding the wafer on the holding surface (1o) and
c) compensation means (3, 4, 5, 6) for the active, at least partial compensation, controllable by temperature and/or shape, of local and/or global distortions of the wafer for the in-situ correction of the alignment errors during the contacting and bonding of the wafers,
- alignment means for the alignment of wafers using compensation by the compensation means,
- checking means for checking the alignment success and means for self-calibration by means of the acquired data.

2. The device according to claim 1, wherein the temperature of the holding surface (1o) can be influenced locally by the compensation means (3, 4, 5, 6).

3. The device according to any one of the preceding claims, wherein a plurality of heating/cooling elements, in particular solely heating elements 3, preferably Peltier elements, are provided as active control elements at the rear side (1r) of the supporting device.

4. The device according to any one of the preceding claims, **characterised in that**, by means of the compensation means (3, 4, 5, 6), the shape of the holding surface (1o) can be influenced locally in a Z-direction, in particular by a preferably mechanical action.

5. The device according to any one of the preceding claims, wherein the holding surface (1o) can be subjected locally to pressure, in particular hydraulically and/or pneumatically, from a rear side (1r) of the holding surface (1o) by the compensation means (3, 4, 5, 6).

6. The device according to any one of the preceding claims, wherein the compensation means (3, 4, 5, 6) are provided as a multiplicity of active control elements (3, 4, 5, 6) integrated, preferably embedded, in the supporting device, in particular in the holding surface (1o).

7. The device according to claim 6, wherein each control element (3, 4, 5, 6) or groups of control elements (3, 4, 5, 6) can be controlled separately.

8. A method for the alignment of a first wafer with a second wafer with the following steps, in particular the following sequence:
- acquisition of position and/or strain maps of the first and/or second wafer,
- supporting of at least one of the wafers on a supporting device for supporting and holding wafers with:
a) a holding surface (1o),
b) holding means for holding the wafer on the holding surface (1o) and
c) compensation means (3, 4, 5, 6) for the active, at least partial compensation, controllable by temperature and/or shape, of local and/or global distortions of the wafer for the in-situ correction of alignment errors during the contacting and bonding of the wafers,
- alignment of the wafers using compensation by the compensation means,
- acquisition of position and/or strain maps of the first and/or second wafer for detecting local alignment errors which have occurred due to strain and/or distortion of the first wafer with respect to the second wafer during the joining of the first wafer with the second wafer,
- checking the alignment success and self-calibration by means of the acquired data.

## Revendications

1. Dispositif pour aligner une première tranche avec une seconde tranche comprenant les attributs suivants :
- un dispositif de détection de cartes de position et/ou de dilatation de la première tranche et/ou de la seconde tranche ainsi que de détection d'erreurs d'alignement locales survenues par la dilatation et/ou la déformation de la première tranche par rapport à la seconde tranche lors de la liaison de la première tranche avec la seconde tranche,
- au moins un dispositif de réception pour recevoir et maintenir les tranches, comprenant :
a) une face de fixation (1o),
b) des moyens de fixation pour fixer la tranche sur la face de fixation (1o) et
c) des moyens de compensation (3, 4, 5, 6) pour la compensation active, au moins partielle, pouvant être commandée par la température et/ou la forme, de déformations locales et/ou globales de la tranche pour la correction in-situ d'erreurs d'alignement lors de la mise en contact et de la liaison des tranches,
- des moyens d'alignement pour l'alignement des tranches par compensation par les moyens de compensation,
- des moyens de vérification pour vérifier le succès d'alignement et des moyens d'auto-calibrage au moyen des données détectées.

2. Dispositif selon la revendication 1, dans lequel la température de la face de fixation (1o) peut être influencée localement par les moyens de compensation (3, 4, 5, 6).

3. Dispositif selon l'une des revendications précédentes, dans lequel une pluralité d'éléments de chauffage/refroidissement, en particulier exclusivement des éléments de chauffage (3), de préférence des éléments à effet Peltier, sont prévus en tant qu'éléments de commande actifs sur un dos (1r) du dispositif de réception.

4. Dispositif selon l'une des revendications précédentes, **caractérisé en ce que** du fait des moyens de compensation (3, 4, 5, 6), la forme de la face de fixation (1o), peut être influencée localement, en particulier par influence, de préférence mécanique, dans un sens Z.

5. Dispositif selon l'une des revendications précédentes, dans lequel la face de fixation (1o) peut être alimentée localement en pression par les moyens de compensation (3, 4, 5, 6), en particulier hydrauliquement et/ou pneumatiquement, par un dos (1r) de la face de fixation (1o).

6. Dispositif selon l'une des revendications précédentes, dans lequel les moyens de compensation (3, 4, 5, 6) sont prévus dans le dispositif de réception, en particulier intégrés, de préférence enchâssés, dans la face de fixation (1o), en tant qu'une pluralité d'éléments de commande (3, 4, 5, 6) actifs.

7. Dispositif selon la revendication 6, dans lequel chaque élément de commande (3, 4, 5, 6) ou des groupes d'éléments de commande (3, 4, 5, 6) peu(ven)t être commandé(s) de manière séparée.

8. Procédé pour aligner une première tranche avec une seconde tranche comprenant les étapes suivantes, en particulier le déroulement suivant :
- détection de cartes de position et/ou de dilatation de la première tranche et/ou de la seconde tranche,
- réception d'au moins une des tranches sur un dispositif de réception pour recevoir et maintenir les tranches, comprenant :
a) une face de fixation (1o),
b) des moyens de fixation pour fixer la tranche sur la face de fixation (1o) et
c) des moyens de compensation (3, 4, 5, 6) pour la compensation active, au moins partielle, pouvant être commandée par la température et/ou la forme, de déformations locales et/ou globales de la tranche pour la correction in-situ d'erreurs d'alignement lors de la mise en contact et de la liaison des tranches,
- alignement des tranches par compensation par les moyens de compensation,
- détection de cartes de position et/ou de dilatation de la première tranche et/ou de la seconde tranche pour la détection d'erreurs d'alignement locales survenues par la dilatation et/ou la déformation de la première tranche par rapport à la seconde tranche lors de la liaison de la première tranche avec la seconde tranche,
- vérification du succès d'alignement et de l'auto-calibrage au moyen des données détectées.
